# EUROPÄISCHE PATENTANMELDUNG

(11) **EP 3 480 616 A1**
(43) Veröffentlichungstag der Anmeldung: **08.05.2019**
(21) Anmeldenummer: 17200151.3
(22) Anmeldetag: 06.11.2017
(51) Int. Cl.: G01R 33/54, G01R 33/36, G05B 19/042

(54) **MAGNETRESONANZ-SYSTEM UND VERFAHREN ZUM ÜBERTRAGEN VON STEUERDATEN AN EINE DIGITALE STEUEREINRICHTUNG EINES MAGNETRESONANZ-SYSTEMS**

(71) Anmelder: Siemens Healthcare GmbH, 91052 Erlangen (DE)
(72) Erfinder: CAMPAGNA, Swen, 91238 Engelthal (DE)

(57) **Zusammenfassung**

Es wird ein MR-System (10) mit einem Steuerrechner (12) und einer digitalen Steuereinrichtung (13) beschrieben. Der Steuerrechner (12) weist einen externen digitalen Bilddatenport (16) zur Übertragung von Sequenzdaten (SQD) umfassenden, als Bilddaten (BD) kodierten Steuerdaten (SD) von dem Steuerrechner (12) zu der Steuereinrichtung (13) auf. Die Steuereinrichtung (13) umfasst einen mit dem externen digitalen Bilddatenport (16) des Steuerrechners (16) kompatiblen Port (6) zum Empfangen der von dem externen digitalen Bilddatenport (4) empfangenen Steuerdaten (SD) und ist dazu eingerichtet, die Sequenzdaten (SQD) aus den empfangenen Steuerdaten (SD) zu extrahieren. Es wird auch ein Verfahren zum Ansteuern einer digitalen Steuereinrichtung (13) durch einen Steuerrechner (12) beschrieben.

## Beschreibung

Die Erfindung betrifft ein MR-System mit einem Steuerrechner und einer digitalen Steuereinrichtung. Weiterhin betrifft die Erfindung ein Verfahren zum Ansteuern einer digitalen Steuereinrichtung durch einen Steuerrechner eines MR-Systems.

In einem Magnetresonanzsystem, auch Magnetresonanztomographiesystem oder Magnetresonanzanlage genannt, wird für die Erstellung von Magnetresonanzaufnahmen üblicherweise der zu untersuchende Körper mit Hilfe eines Grundfeldmagnetsystems einem relativ hohen Grundmagnetfeld, beispielsweise von 1,5 Tesla, 3 Tesla oder 7 Tesla, ausgesetzt. Zusätzlich wird mit Hilfe eines Gradientensystems ein Magnetfeldgradient angelegt. Über ein Hochfrequenz-Sendesystem werden dann mittels geeigneter Antenneneinrichtungen hochfrequente Anregungssignale (HF-Signale) ausgesendet, was dazu führen soll, dass die Kernspins bestimmter, durch dieses Hochfrequenzfeld resonant angeregter Atome um einen definierten Flipwinkel gegenüber den Magnetfeldlinien des Grundmagnetfelds verkippt werden. Bei der Relaxation der Kernspins werden Hochfrequenzsignale, so genannte Magnetresonanzsignale, abgestrahlt, die von einem Hochfrequenz-Empfangssystem mittels geeigneter Empfangsantennen empfangen und dann weiterverarbeitet werden. Aus den so akquirierten Rohdaten können schließlich die gewünschten Bilddaten rekonstruiert werden.

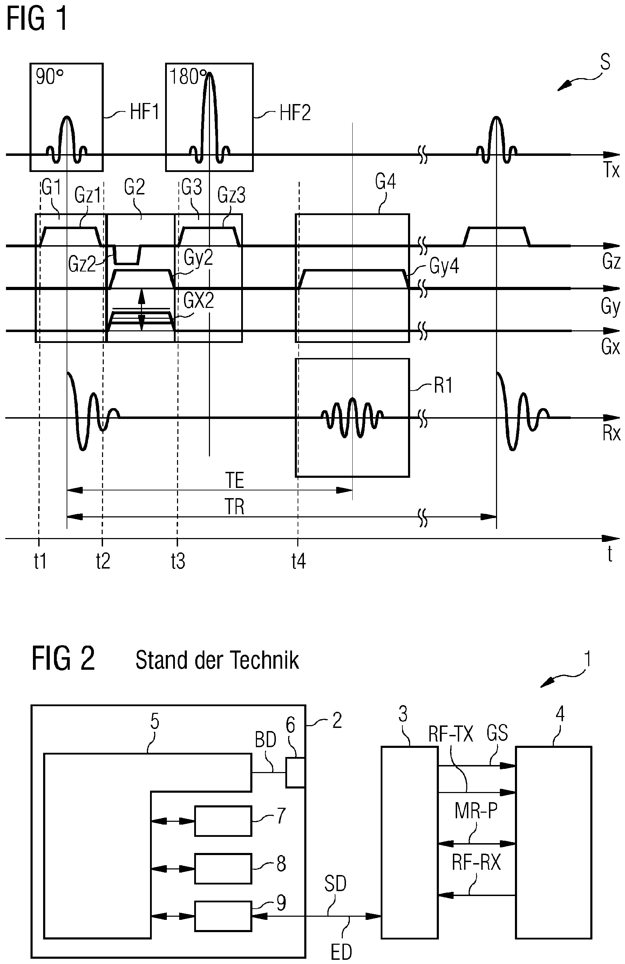

Für eine bestimmte Messung ist folglich eine bestimmte Pulssequenz auszusenden, welche aus einer Folge von Hochfrequenzpulsen, insbesondere Anregungspulsen und Refokussierungspulsen sowie passend dazu koordiniert auszusendenden Gradientenpulsen in verschiedenen Raumrichtungen besteht. Zeitlich passend hierzu müssen Auslesefenster für das Hochfrequenz-Empfangssystem gesetzt werden, während dessen die induzierten Magnetresonanzsignale erfasst werden. Für die Bildgebung maßgeblich ist dabei insbesondere das Timing innerhalb der Sequenz, d. h. in welchen zeitlichen Abständen welche Pulse aufeinander folgen. In FIG 1 ist ein Beispiel einer solchen Pulssequenz gezeigt.

Ein MR-System besitzt zumindest einen Steuerrechner, auf welchem die genannte Sequenz ausgeführt wird. Weiterhin umfasst ein MR-System eine digitale Steuereinrichtung, welche von dem Steuerrechner Steuerdaten, welche die Pulssequenz umfassen, empfängt und demensprechend Pulse, wie zum Beispiel Gradientenpulse, HF-Pulse usw. ausspielt, mit denen der Bildgebungsprozess durchgeführt wird.

In FIG 2 ist eine herkömmliche Anordnung eins MR-Systems mit einem Steuerrechner und einer von dem Steuerrechner angesteuerten digitalen Steuereinrichtung gezeigt.

Als Steuerrechner und Bildrekonstruktionsrechner wird gerne ein Standard-Rechner verwendet. Aus Kostengründen ist es hier besonders vorteilhaft, einen möglichst nicht modifizierten Rechner "von der Stange" zu nehmen und darauf die MR-spezifische Software laufen zu lassen (insbesondere die Software zur Steuerung der Messung, also die sogenannte "Sequenz"). Sowohl dies als auch der Empfang der MR-Rohdaten bedingt ein Echtzeit-Betriebssystem, da in jedem Fall mit für das MR-System spezifischer Hardware kommuniziert werden muss und die dort realisierten Datenpuffer eine beschränkte Größe haben und insbesondere die Daten zur Ansteuerung der MR-System-spezifischen Hardware mit sehr kurzem zeitlichen Vorlauf übertragen werden sollen.

Die für das MR-System spezifische digitale Steuereinrichtung realisiert die Ausführung dieser Anweisungen der Sequenz. Da hierbei eine extrem zeitkritische und jitter-freie Synchronisation der verschiedenen Subsysteme bzw. deren Aktivitäten (Gradient, TY, RX, Peripherie) wichtig ist, kann dieser Vorgang nicht allein mit Software realisiert werden, sondern benötigt eine taktgenaue Implementierung beispielsweise mit Hilfe von FPGAs.

Herkömmlich wird ein Teil der für das MR-System spezifischen Hardware zumindest in Teilen in dem Steuerrechner untergebracht, um die digitale Steuereinrichtung mit sehr kurzen Kommunikationszeiten mit den aus der Sequenz generierten Anweisungen versorgen zu können. Einfacher und kostengünstiger wäre die Verwendung von externen Kommunikations-Schnittstellen, die ein Rechner von Haus aus mitbringt, beispielsweise USB-Schnittstellen oder Ethernet-Schnittstellen.

Leider sind diese externen OTS-Schnittstellen (OTS = off the shelf = als Standardprodukt ausgelegt) nicht oder nur sehr schlecht nutzbar, da die Daten in der Regel durch umfangreiche Software-Schichten des Betriebssystems und/oder nicht beeinflussbare Hardware-Protokolle hindurchgeschleust werden müssen und daher ein zeitkritisches Ausspielen von Steuerbefehlen nicht exakt möglich ist. Daher wird in einem solchen Fall die Verbindung über die Rechner-internen Busse, beispielsweise PCIe-Bussysteme, genutzt, für welche man eigene Treiber schreiben kann und man somit das Timing hinreichend unter Kontrolle hat. Der große Nachteil dabei ist, dass man hierdurch Schnittstellen des Rechners nutzt, welche nur intern zugänglich sind, d.h. für eine Installation einer solchen Schnittstelle muss der Rechner geöffnet werden und durch zusätzliche Hardware ergänzt werden. Ideal wäre ein einfaches Anschließen der MR-spezifischen Hardware mittels Kabel bzw. Stecker an eine vorhandene standard-externe Schnittstelle, wie zum Beispiel USB oder Ethernet, ohne ein notwendiges Öffnen und damit Modifizieren des Rechners.

Die Synchronisation der o. g. Systemkomponenten bzw. Teilsysteme und der dazu gehörigen Gerätetypen innerhalb des geforderten Genauigkeitsbereichs stellt hohe Anforderungen an die Steuerung und damit auch an das zeitlich korrekte Ausspielen und Übertragen der Pulssequenz durch den Steuerrechner des MR-Systems an die Steuereinrichtung.

Die DE 102006052437 A1 und die DE 102008017819 B3 zeigen jeweils einen Aufbau eines MR-Steuerungssystems, die DE 102007058872 A1, die US 20090137898 A1, US 20160174928 A1 jeweils Vorrichtungen zur Datenübertragung in einem MR-System.

Es ist eine Aufgabe der vorliegenden Erfindung, eine einfachere und zugleich ausreichend zuverlässige und präzise Art der Sequenzdatenübertragung zwischen dem Steuerrechner und einer digitalen Steuereinrichtung eines MR-Systems zu schaffen.

Diese Aufgabe wird zum einen durch ein MR-System gemäß Patentanspruch 1 und zum anderen durch ein Verfahren zum Ansteuern einer digitalen Steuereinrichtung durch einen Steuerrechner eines MR-Systems gemäß Patentanspruch 7 gelöst.

Bei dem erfindungsgemäßen MR-System mit einem Steuerrechner und einer digitalen Steuereinrichtung weist der Steuerrechner einen externen digitalen Bilddatenport zur Übertragung von als Bilddaten kodierten, Sequenzdaten umfassenden Steuerdaten von dem Steuerrechner zu der digitalen Steuereinrichtung auf. Als externer digitaler Bilddatenport soll in diesem Zusammenhang eine externe Schnittstelle zur Übertragung von Bilddaten an eine Bilddarstellungseinrichtung oder eine bildverarbeitende Einrichtung verstanden werden.

Die digitale Steuereinrichtung umfasst erfindungsgemäß einen mit dem externen digitalen Bilddatenport des Steuerrechners kompatiblen Port zum Empfangen der von dem externen digitalen Bilddatenport übermittelten, als Bilddaten kodierten Steuerdaten und ist dazu eingerichtet, die Sequenzdaten aus den empfangenen, als Bilddaten kodierten Steuerdaten zu extrahieren. Hierzu kann eine an ein für die Übertragung der als Bilddaten kodierten Steuerdaten verwendetes Protokoll angepasste Software, beispielsweise ein Computerprogramm, in der digitalen Steuereinrichtung genutzt werden. Der Extraktionsvorgang kann auch mit Hilfe eines modifizierten Hardware-Bauelements, beispielsweise eines entsprechend angepassten FPGA-Bausteins, erfolgen. Vorteilhaft kann eine in dem Steuerrechner vorhandene Schnittstellenarchitektur unverändert für eine echtzeitkritische Datenübertragung an die digitale Steuereinrichtung genutzt werden. Dabei müssen an der Hardware des Steuerrechners intern keine Modifikationen vorgenommen werden. Stattdessen wird mit Hilfe eines in dem Steuerrechner ablaufenden, geeignet modifizierten Programms, also einer Software, der Datenfluss der Steuerdaten zu dem standardmäßig vorhandenen digitalen Bilddatenport umgeleitet. Anders ausgedrückt, werden die Steuerdaten, welche nach extern zur digitalen Steuereinrichtung übertragen werden sollen, nur entsprechend "eingepackt". D.h., sie werden entsprechend dem Protokoll des digitalen Bilddatenports konvertiert und direkt in den Framebuffer geschrieben. Dabei kann für den Fall einer in die Hauptplatine integrierten Grafikkarte ein direktes Schreiben des Sequenz-Frameworks, also der für die Sequenzdatenerzeugung verwendeten Software, in den RAM-Speicher erfolgen. Bei dieser bevorzugten Variante ist der RAM-Speicher der CPU gleichzeitig der Pufferspeicher des digitalen Bilddatenports. D.h. es wird zum Zeitpunkt des Ausspielens der Sequenz (zur runtime) eben keinerlei Treiber oder ein anderer Betriebs-System-Mechanismus benötigt (bzw. nur initial zum Setup), was ein zeitkritsches Übertragen und Ausspielen von Pulssequenzen ermöglicht bzw. vereinfacht.

Im Gegensatz zu herkömmlichen Anordnungen, muss die für die Übertragung der Steuerdaten genutzte Schnittstelle nicht intern zusätzlich installiert werden, so dass der Aufwand für den Anschluss eines neuen Steuerrechners in einem MR-System reduziert ist.

Bei dem erfindungsgemäßen Verfahren zum Ansteuern einer digitalen Steuereinrichtung eines MR-Systems durch einen Steuerrechner werden über einen externen digitalen Bilddatenport des Steuerrechners, beispielsweise mit einem spezifischen Daten-Protokoll, Sequenzdaten umfassende, als Bilddaten kodierte Steuerdaten zu der digitalen Steuereinrichtung übermittelt. Dies geschieht vorteilhaft mit einer geeignet modifizierten Software, mit der die Sequenzdaten in einen Bildspeicher, vorzugsweise den erwähnten RAM-Speicher, des Bilddatenports geschrieben werden. Dabei wird gegebenenfalls die Zeitabfolge der Übertragung der Steuerdaten an die Zeitabfolge der Bilddatenübertragung des Bilddatenports angepasst. Die als Bilddaten kodierten Steuerdaten werden von einem mit dem externen digitalen Bilddatenport des Steuerrechners kompatiblen Port der digitalen Steuereinrichtung empfangen. Hierfür wird das Daten-Protokoll des externen digitalen Bilddatenports in der digitalen Steuereinrichtung implementiert. Schließlich werden die Sequenzdaten aus den empfangenen Steuerdaten extrahiert. Das erfindungsgemäße Verfahren teilt die Vorteile des erfindungsgemäßen MR-Systems.

Die abhängigen Ansprüche sowie die nachfolgende Beschreibung enthalten besonders vorteilhafte Weiterbildungen und Ausgestaltungen der Erfindung, wobei insbesondere auch die Ansprüche einer Kategorie analog zu den abhängigen Ansprüchen einer anderen Anspruchskategorie und deren Beschreibungsteilen weitergebildet sein können und Merkmale von verschiedenen Ausführungsbeispielen zu neuen Ausführungsbeispielen kombiniert werden können.

In einer Ausgestaltung des erfindungsgemäßen MR-Systems ist die digitale Steuereinrichtung dazu eingerichtet, das Daten-Protokoll des externen digitalen Bilddatenports zu implementieren. Vorteilhaft wird der Ausleseprozess in der digitalen Steuereinrichtung an das modifizierte Datenprotokoll der verwendeten Grafikschnittstelle angepasst, so dass ein korrekter Empfang der Steuerdaten erfolgen kann.

In einer besonders bevorzugten Ausgestaltung des erfindungsgemäßen MR-Systems umfasst der Steuerrechner einen Rechner mit einem Echtzeitbetriebssystem. Ein Echtzeitbetriebssystem erlaubt eine garantierte Reaktivität des Steuerrechners im Rahmen des Steuerdatenübertragungsprozesses. Bei der Nutzung von Hardwarepuffern, wie dem genannten Framebuffer, ist eine solche garantierte Reaktivität, außer bei sehr ausgeprägten Zeitlatenzen, notwendig.

In einer Variante des erfindungsgemäßen MR-Systems wird ein sogenanntes Double-Buffering angewandt. Damit hat es folgendes auf sich: Während ein Bild ausgegeben wird (entspricht einem Speicherbereich im Bildspeicher (Framebuffer), beispielsweise dem RAM-Speicher des Steuerrechners) kann die Software ein neues Bild in einem weiteren separaten Speicherbereich berechnen. Wurde das erste Bild vollständig ausgegeben, dann wird zur Ausgabe des nächsten Bildes auf den zweiten Speicherbereich umgeschaltet und der erste Speicherbereich kann "ungestört" durch die Software wieder neu beschrieben werden. Auf diese Weise gewinnt man etwas zeitlichen Vorlauf beim Füllen des Framebuffers. Diese Vorgehensweise kann nun auf das Beschreiben des Framebuffers mit den Steuerdaten angewendet werden. Auch in diesem Fall gewinnt man Zeit, um die Sequenzdaten zu bestimmen und in den Framebuffer zu schreiben.

Die Erfindung wird im Folgenden unter Hinweis auf die beigefügten Figuren anhand von Ausführungsbeispielen noch einmal näher erläutert. Es zeigen:
FIG 1 eine beispielhafte Pulssequenz, welche mit dem erfindungsgemäßen MR-System zeitlich korrekt ausgespielt werden kann, unterteilt in Eventblöcke,
FIG 2 ein Blockschaltbild eines Magnetresonanzsystems nach dem Stand der Technik,
FIG 3 ein Blockschaltbild eines Ausführungsbeispiels eines erfindungsgemäßen Magnetresonanzsystems,
FIG 4 ein Blockschaltbild eines alternativen Ausführungsbeispiels eines erfindungsgemäßen Magnetresonanzsystems,
FIG 5 ein Flussdiagramm, welches ein Verfahren zum Ansteuern einer digitalen Steuereinrichtung durch einen Steuerrechner eines MR-Systems gemäß einem Ausführungsbeispiel der Erfindung veranschaulicht.

In FIG 1 ist ein übliches Pulsdiagramm am Beispiel einer Spin-Echo-Sequenz S veranschaulicht. In diesem Pulsdiagramm sind auf verschiedenen Zeitachsen übereinander die verschiedenen Pulse dargestellt, die von unterschiedlichen Systemkomponenten eines Magnetresonanzbildgebungssystems ausgeführt werden müssen. Für das Ausspielen der Pulse werden zunächst von einem Steuerrechner entsprechende Befehlssequenzen erzeugt und an eine digitale Steuereinrichtung übermittelt. Die digitale Steuereinrichtung erzeugt verschiedene Arten von Steuersignalen zum Aussenden und Empfangen von verschiedenen Arten von Pulsen, die in FIG 1 gezeigt sind.

Auf der obersten Achse (Sendeachse Tx) ist das auszusendende Hochfrequenzsignal dargestellt. Bei dieser Spin-Echo-Sequenz S müssen nacheinander zwei Hochfrequenzpulse HF1, HF2 ausgesendet werden, zum einen ein 90°-Anregungspuls HF1 und dann in einem bestimmten Abstand ein 180°-Refokussierungspuls HF2. Da beide Hochfrequenzpulse HF1, HF2 räumlich selektiv wirken sollen, ist jeweils gleichzeitig ein Schichtselektionsgradientenpuls Gz1, Gz3 zu schalten, was auf der zweiten Achse von oben, der Schichtselektionsachse Gz dargestellt ist. Zwischen diesen beiden Schichtselektionsgradientenpulsen Gz1, Gz3 in Schichtselektionsrichtung werden ein weiterer Schichtselektionsgradientenpuls Gz2 in negativer Richtung sowie ein Frequenzkodiergradientenpuls Gy2 auf der Frequenzkodierachse Gy (dritten Achse von oben) und ein Phasenkodiergradientenpuls Gx2 in der Phasenkodierrichtung, d.h. auf der Phasenkodierachse Gx, ausgesendet. Die einzelnen Gradientenpulse Gz1, Gz2, Gz3, Gy2, Gx2 für die verschiedenen Raumrichtungen sind hier jeweils als Gradientenereignisse G1, G2, G3 zusammengefasst.

Nach einer bestimmten Echozeit TE nach dem Maximum des ersten Hochfrequenzpulses HF1 erfolgt dann ein Echosignal, welches zur Erfassung der Rohdaten für die Bildrekonstruktion erfasst werden muss. Hierzu wird gleichzeitig ein Auslesefenster R1 als ein Ereignis am ADC der Empfangseinrichtung geschaltet (siehe Ausleseachse Rx). Gleichzeitig wird ein Auslesegradientenpuls Gy4 ausgespielt, welcher als Gradientenereignis G4 dargestellt ist. Nach einer Repetitionszeit TR wird die Sequenz S dann wiederholt, wobei der Phasenkodiergradientenpuls Gx2 dann so lange jeweils mit einer anderen Amplitude gesetzt wird, bis eine gewünschte Schicht ausgelesen ist.

Wie hier dargestellt, beginnen die einzelnen Ereignisse, welche durch die Steuerbefehle initiiert werden bzw. insofern die Steuerbefehle darstellen, d. h. das Ausspielen der Hochfrequenzpulse HF1, HF2 und der Gradientenereignisse G1, G2, G3, G4 und das Setzen des Auslesefensters R1, zu ganz genau definierten Zeiten bzw. Zeitpunkten t1, t2, t3, t4 bezüglich der Systemzeit t (siehe unterste Achse des Sequenzdiagramms in FIG 1). Um die genannten zeitkritischen Operationen synchronisiert ausführen zu können, müssen die für die Erzeugung der beschriebenen Pulse notwendigen Befehlssequenzen durch den Steuerrechner zeitlich exakt ausgegeben und an die digitale Steuereinrichtung des Magnetresonanzbildgebungssystems in einer festgelegten Zeit übertragen werden.

In FIG 2 ist ein vereinfachtes Blockschaltbild eines herkömmlichen Magnetresonanzsystems 1 dargestellt. Ein solches herkömmliches Magnetresonanzsystem 1 umfasst einen Steuerrechner 2, eine digitale Steuereinrichtung 3 und die eigentliche Magnetresonanzscaneinheit 4.

Wie bereits erwähnt, werden zunächst die für die Erzeugung der beschriebenen Pulse notwendigen Befehlssequenzen durch den Steuerrechner 2 zeitlich exakt ausgegeben und an die digitale Steuereinrichtung 3 des Magnetresonanzbildgebungssystems in einer festgelegten Zeit übertragen. Von der digitalen Steuereinrichtung 3 werden dann einzelne Komponenten der Scaneinheit 4 des Magnetresonanzsystems angesteuert. Hierzu werden von der digitalen Steuereinrichtung 3 die erforderlichen Steuerbefehle GS, RF-TX generiert und zur passenden Zeit an die einzelnen Systemkomponenten der Scaneinheit 4 übersendet, so dass diese zum passenden Zeitpunkt relativ zueinander die Befehle ausführen und somit die gewünschten physikalischen Ereignisse eintreten.

Der Steuerrechner 2 umfasst eine zentrale Prozesseinheit 5, welche zur Pulssequenzerzeugung und zur Rekonstruktion von Bilddaten auf Basis von Rohdaten genutzt wird. Die zentrale Prozesseinheit 5 steht über einen integrierten Grafikchip in Verbindung mit einer digitalen Video-Schnittstelle 6 zur Ansteuerung eines Grafikbildschirms zur Darstellung von Bilddaten BD. Weiterhin arbeitet die zentrale Prozesseinheit 5 mit einem RAM-Speicher 7 zusammen und steht mit einer Mehrzahl von Schnittstellen 8 zu Peripheriesystemen in Verbindung. Echtzeitkritische Steuerdaten SD zur Erzeugung von Pulssequenzen werden von der zentralen Prozesseinheit 5 über eine PCIe-Steckkarte 9 an die digitale Steuereinrichtung 3 übermittelt. Ergebnisdaten ED, beispielsweise Rohdaten, werden von der digitalen Steuereinrichtung 3 über die PCIe-Karte 9 an die zentrale Prozesseinheit 5 übermittelt.

Die digitale Steuereinrichtung 3 kann darüber hinaus noch eine Vielzahl weiterer Komponenten aufweisen, beispielsweise Komponenten zur Weiterverarbeitung der von dem Hochfrequenz-Empfangssystem der Scaneinheit 4 empfangenen Signale RF-RX bzw. Rohdaten sowie ggf. Rekonstruktionseinheiten, um die Bilddaten aus den Rohdaten zu rekonstruieren etc.

Die Scaneinheit 4 umfasst zum Beispiel ein Gradientensystem mit drei Magnetfeldgradientenspulen zur Erzeugung von Magnetfeldgradienten Gx, Gy, Gz in x-, y- und z-Richtung. Diese Magnetfeldgradientenspulen für die verschiedenen Raumrichtungen sind unabhängig voneinander ansteuerbar, so dass durch eine vorgegebene Kombination Gradienten in beliebigen logischen Raumrichtungen, beispielsweise in Schichtselektionsrichtung, in Phasenkodierrichtung oder in Ausleserichtung, angelegt werden können. Dabei sind diese Richtungen in der Regel von der gewählten Schichtorientierung abhängig. Ebenso können die logischen Raumrichtungen aber auch mit den x-, y- und z-Richtungen übereinstimmen, beispielsweise Schichtselektionsrichtung in z-Richtung, Phasenkodierrichtung in y-Richtung und Ausleserichtung in x-Richtung.

Weiterhin gehören zu diesen zeitkritisch bzw. koordiniert mit entsprechenden Pulssequenzen anzusteuernden Systemkomponenten der Scaneinheit 4 ein Hochfrequenz-Sendesystem und ein Hochfrequenz-Empfangssystem. Das Hochfrequenz-Sendesystem umfasst in der Regel wiederum mehrere Teilsysteme bzw. Teilkomponenten, beispielsweise mehrere Sendespulen (bzw. Sendeantennen), mit zugehörigen Sendeverstärkern etc. Entsprechend kann das Hochfrequenz-Empfangssystem auch eine nahezu beliebige Anzahl von Teilempfangssystemen mit jeweils einzelnen Empfangsspulen (bzw. Empfangsantennen), Vorverstärkern, Analog-Digital-Wandlern etc. aufweisen. Hier sind mehrere Empfangsspulen als Teilsysteme bzw. Teilkomponenten dargestellt.

Bei den Sendespulen, um die Hochfrequenzsignale auszusenden, kann es sich beispielsweise um eine übliche Ganzkörperspule handeln sowie ggf. zusätzliche Lokalspulen. Als Empfangsspulen können ebenfalls diese Sendespulen verwendet werden, soweit sie zwischen Empfangs- und Sendemodus umschaltbar sind. Grundsätzlich ist es aber auch möglich, separate Empfangsspulen einzusetzen.

Neben den genannten Systemkomponenten weist eine solche Scaneinheit 4 natürlich noch eine Vielzahl weiterer Systemkomponenten oder Teilsysteme auf, insbesondere ein Grundfeldmagnetsystem, um das Untersuchungsobjekt bzw. den Patienten (nicht dargestellt) zunächst mit einem Grundmagnetfeld zu beaufschlagen.

In der Scaneinheit 4 ist mittig ein Patiententunnel (Bore) angeordnet, in welchen das Untersuchungsobjekt auf einem beweglichen Tisch hinein- und herausfahrbar bzw. an beliebiger Stelle im Bore positionierbar ist. Das Grundmagnetfeldsystem ist so aufgebaut, dass in einem definierten zentralen Bereich innerhalb dieses Bores ein möglichst homogenes Grundmagnetfeld anliegt. Die Gradientenspulen sind entsprechend so gewickelt, dass wie zuvor beschrieben in verschiedenen Richtungen dem Grundmagnetfeld innerhalb des Bores ein Magnetfeldgradient überlagert werden kann, und die Sende- und Empfangsspulen sind entsprechend so angeordnet, dass sie innerhalb dieses Bores die Hochfrequenzsignale in bestimmte Bereiche aussenden bzw. aus diesen empfangen. All diese Systemkomponenten sind dem Fachmann aber bekannt und brauchen daher hier nicht im Einzelnen weiter erläutert zu werden. Es wird an dieser Stelle auch darauf hingewiesen, dass nicht nur ein zuvor genanntes Magnetresonanzsystem mit einem Bore auf die erfindungsgemäße Weise angesteuert werden kann, sondern beispielsweise auch seitlich offene, U-förmige Magnetresonanzsysteme oder Magnetresonanzsysteme kleinerer Art für einzelne Gliedmaßen etc. Wie hier dargestellt, werden die einzelnen Komponenten der Scaneinheit über Steuerbefehle GS, RF-TX, MR-P für Gradienten, für HF-Anregungssignale und für nicht-zeitkritische Prozesse von der digitalen Steuereinrichtung 3 angesteuert.

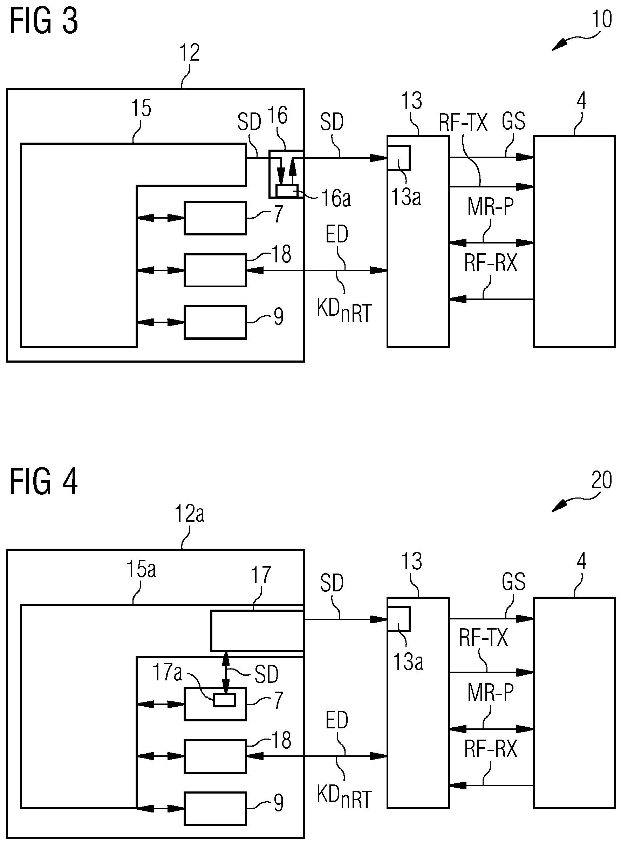

In FIG 3 ist ein vereinfachtes Blockschaltbild eines Magnetresonanzsystems 10 gemäß einem Ausführungsbeispiel der Erfindung dargestellt. Im Vergleich zu dem in FIG 2 gezeigten herkömmlichen Magnetresonanzsystem 1 sind der Steuerrechner 12 und die digitale Steuerungseinrichtung 13 in FIG 3 anders aufgebaut bzw. werden anders angesteuert. Der Steuerrechner 12 umfasst ebenfalls eine zentrale Prozesseinheit 15 mit einer separaten Grafikkarte. Die zentrale Prozesseinheit 15 wird nun aber zusätzlich dazu genutzt, in einen Framepufferspeicher 16a, auch Framebuffer genannt, einer Grafikschnittstelle 16, d.h. einer Schnittstelle 16 für eine grafische Anzeige, als Grafikdaten bzw. Bilddaten kodierte Steuerdaten SD zu schreiben und diese Steuerdaten SD über die Schnittstelle 16, auch externer digitaler Bilddatenport genannt, an eine digitale Steuereinrichtung 13 zu übermitteln. Hierfür kann eine dafür geeignete Software zur Erzeugung und Ausgabe von Pulssequenzen bzw. Steuerbefehlen derart modifiziert werden, dass die Steuerdaten SD an die grafische Schnittstelle 16 weitergeleitet werden. Die digitale Steuereinrichtung 13 weist zum Empfang dieser Steuerdaten SD einen mit dem externen digitalen Bilddatenport 16 kompatiblen digitalen Port 13a auf. Dieser zusätzliche digitale Port 13a ist dazu eingerichtet, die Sequenzdaten aus den empfangenen Steuerdaten SD zu extrahieren. Hierzu ist der zusätzliche Port physikalisch an die grafische Schnittstelle 16 des Steuerrechners 12 und das von der grafischen Schnittstelle 16 des Steuerrechners 12 verwendete Protokoll angepasst. Zudem sollte auch die Software der digitalen Steuereinrichtung 13 an die zeitliche Taktung der Bildausgabe angepasst sein.

D.h., die Software der digitalen Steuereinrichtung 13 muss darauf angepasst sein, die als Bilddaten kodierten Steuerdaten SD aus dem externen digitalen Bilddatenport 16 bzw. dem diesem zugeordneten Framepufferspeicher 16a zu lesen. Auf diese Weise kann die für die digitale Steuereinrichtung 13 spezifische Software, d.h. die zur Pulssequenzerzeugung im Steuerrechner 12 genutzte Software, direkt unter Ausnutzung der grafischen Schnittstelle 16 mit der digitalen Steuereinrichtung 13 kommunizieren.

In dem in FIG 3 gezeigten Fall ist die Grafikkarte 16 separat von der CPU mit einem separaten Framebufferspeicher 16a ausgebildet.

Wie bereits erwähnt, ist der Transport von Sequenzdaten bzw. diese umfassenden Steuerdaten SD aus dem Steuerrechner 12 heraus zur digitalen Steuereinrichtung 13 besonders zeitkritisch. Dagegen lassen sich für den Datentransport von Empfangsdaten ED bzw. nicht zeitkritischen Kommunikationsdaten KD_{nRT} in dem Steuerrechner 12 leichter zugängliche externe Schnittstellen, wie zum Beispiel Ethernet-Schnittstellen oder USB-Schnittstellen, verwenden, so dass eine nicht-zeitkritische bidirektionale Kommunikation des Steuerrechners 12 mit der digitalen Steuereinrichtung 13 über standardmäßig bereits vorhandene externe Rechnerschnittstellen möglich ist.

In FIG 4 ist ein vereinfachtes Blockschaltbild eines Magnetresonanzsystems 20 gemäß einem alternativen Ausführungsbeispiel der Erfindung dargestellt. Das in FIG 4 gezeigte MR-System 20 unterscheidet sich von dem in FIG 3 gezeigten Ausführungsbeispiel allein darin, dass ein etwas anders aufgebauter Steuerrechner 12a verwendet wird, der eine CPU 15a verwendet, in die eine Grafikeinheit 17 direkt integriert ist (onboard Grafik). Daher kann die Grafikschnittstelle 17 mit Daten versorgt werden, die direkt im Hauptspeicher 7 der zentralen Prozesseinheit 15a, beispielsweise ein RAM-Speicher, liegen, so dass hier ein zeitlich präzise getaktetes Auslesen von Steuerdaten SD besonders einfach zu realisieren ist. D.h., der Framebufferspeicher 17a, wird bei dieser Variante als Abschnitt des RAM-Speichers bzw. Hauptspeichrers 7 realisiert.

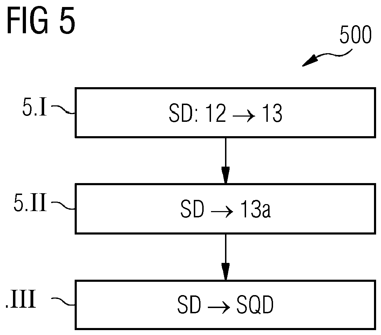

In FIG 5 ist ein Flussdiagramm 500 gezeigt, welches ein Verfahren zum Ansteuern einer digitalen Steuereinrichtung durch einen Steuerrechner eines MR-Systems gemäß einem Ausführungsbeispiel der Erfindung veranschaulicht. Bei dem Schritt 5.I werden zunächst über einen externen digitalen Bilddatenport 16 des Steuerrechners 12 Sequenzdaten SQD umfassende Steuerdaten SD zu der Steuereinrichtung 13 übertragen.

Die Steuerdaten SD werden bei dem Schritt 5.II von einem mit dem externen digitalen Bilddatenport 16 des Steuerrechners 12 kompatiblen Port 13a der digitalen Steuereinrichtung 13 empfangen. Schließlich werden bei dem Schritt 5.III in der digitalen Steuereinrichtung 13 die Sequenzdaten SQD aus den empfangenen Steuerdaten SD extrahiert.

Es wird abschließend noch einmal darauf hingewiesen, dass es sich bei den zuvor beschriebenen detaillierten Verfahren und Aufbauten um Ausführungsbeispiele handelt und dass das Grundprinzip auch in weiten Bereichen vom Fachmann variiert werden kann, ohne den Bereich der Erfindung zu verlassen, soweit er durch die Ansprüche vorgegeben ist. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können. Ebenso schließt der Begriff "Einheit" nicht aus, dass diese aus mehreren Komponenten besteht, die gegebenenfalls auch räumlich verteilt sein können.

## Patentansprüche

1. MR-System (10, 20) mit einem Steuerrechner (12, 12a) und einer digitalen Steuereinrichtung (13), wobei
- der Steuerrechner (12, 12a) einen externen digitalen Bilddatenport (16, 17) zur Übertragung von Sequenzdaten (SQD) umfassenden, als Bilddaten (BD) kodierten Steuerdaten (SD) von dem Steuerrechner (12, 12a) zu der Steuereinrichtung (13) umfasst und
- die Steuereinrichtung (13)
- einen mit dem externen digitalen Bilddatenport (16, 17) des Steuerrechners (12, 12a) kompatiblen Port (13a) zum Empfangen der von dem externen digitalen Bilddatenport (16, 17) empfangenen Steuerdaten (SD) umfasst und
- dazu eingerichtet ist, die Sequenzdaten (SQD) aus den empfangenen, als Bilddaten (BD) kodierten Steuerdaten (SD) zu extrahieren.

2. MR-System (20) nach Anspruch 1, wobei der Steuerrechner (12a) eine Hauptplatine mit einem integrierten Grafikprozessor (17) aufweist, welcher dazu eingerichtet ist, die Steuerdaten (SD) zeitlich getaktet an die digitale Steuereinrichtung (13) zu übertragen.

3. MR-System (10) nach Anspruch 1, wobei der Steuerrechner (12) einen separaten Grafikprozessor (16) aufweist.

4. MR-System (10) nach Ansprüche 3, wobei der Steuerrechner (12) eine Software aufweist, welche dazu eingerichtet ist,
- die Steuerdaten (SD) in einen Bildspeicher (16a) des Bilddatenports (16) zu schreiben,
- und dabei die Zeitabfolge der Übertragung der Steuerdaten (SD) an die Zeitabfolge der Bilddatenübertragung des Bilddatenports (16) anzupassen.

5. MR-System (10, 20) nach einem der vorstehenden Ansprüche, wobei die MR-Steuereinrichtung (13) dazu eingerichtet ist, das Daten-Protokoll des externen digitalen Bilddatenports (16, 17) zu implementieren.

6. MR-System (10) nach einem der vorstehenden Ansprüche, wobei der Steuerrechner (12, 12a) einen Rechner mit einem Echtzeitbetriebssystem umfasst.

7. Verfahren zum Ansteuern einer digitalen Steuereinrichtung (13) durch einen Steuerrechner (12, 12a) eines MR-Systems, wobei
- über einen externen digitalen Bilddatenport (16, 17) des Steuerrechners (12, 12a) Sequenzdaten (SQD) umfassenden, als Bilddaten (BD) kodierten Steuerdaten (SD) zu der Steuereinrichtung (13) übertragen werden und
- die als Bilddaten (BD) kodierten Steuerdaten (SD) von einem mit dem externen digitalen Bilddatenport (16, 17) des Steuerrechners (12, 12a) kompatiblen Port (13a) der digitalen Steuereinrichtung (13) empfangen werden und
- die Sequenzdaten (SQD) aus den empfangenen Steuerdaten (SD) extrahiert werden.
